(19) Europäisches Patentamt
European Patent Office
Office européen des brevets

(11) **EP 3 358 738 A1**

(12) **EUROPÄISCHE PATENTANMELDUNG**

(43) Veröffentlichungstag:
08.08.2018 Patentblatt 2018/32

(51) Int Cl.:
*H02M 7/537* (2006.01)    *H02M 7/00* (2006.01)
*H01L 29/00* (2006.01)    *H03K 17/567* (2006.01)
*H03K 17/687* (2006.01)

(21) Anmeldenummer: 17154499.2

(22) Anmeldetag: 03.02.2017

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Siemens Aktiengesellschaft**
**80333 München (DE)**

(72) Erfinder:
• **Donat, Albrecht**
**91462 Dachsbach (DE)**

• **Heinemann, Gerhard**
**91058 Erlangen (DE)**
• **Ibach, Frank**
**92348 Berg b. Neumarkt i. d. Oberpfalz (DE)**
• **Imrich, Franz**
**91058 Erlangen (DE)**
• **Jungwirth, Thomas**
**91301 Forchheim (DE)**
• **Lorz, Roland**
**91341 Röttenbach (DE)**
• **Namyslo, Lutz**
**91353 Hausen (DE)**
• **Weidauer, Jens**
**90763 Fürth (DE)**

(54) **LEISTUNGSHALBLEITERSCHALTUNG**

(57)    Leistungshalbleiterschaltung mit
- zwei Gleichspannungsanschlüssen,
- wenigstens einer Halbbrücke, die zwischen die Gleichspannungsanschlüsse geschaltet ist, wobei die Halbbrücke zwei seriell geschaltete Schalteinheiten umfasst, wobei jede Schalteinheit einen Leistungshalbleiterschalter oder mehrere parallel geschaltete Leistungshalbleiterschalter umfasst,
- einem Wechselspannungsanschluss für jede der Halbbrücken,
- einer Gate-Treiberschaltung für jede der Schalteinheiten,
- einem Kommutierungskondensator parallel zur Halbbrücke,
- einer Modulsteuerung,
- einer Messeinrichtung zur Bestimmung des Stroms zum Wechselspannungsanschluss,
wobei die Halbbrücke, der Kommutierungskondensator und die Gate-Treiberschaltung auf einer gemeinsamen Leiterplatte aufgebaut sind.

FIG 1

**Beschreibung**

Die Erfindung betrifft eine Leistungshalbleiterschaltung mit zwei Gleichspannungsanschlüssen und wenigstens einer Halbbrücke, die zwischen die Gleichspannungsanschlüsse geschaltet ist, wobei die Halbbrücke zwei Schalteinheiten umfasst, wobei jede Schalteinheit einen Leistungshalbleiterschalter oder mehrere parallele Leistungshalbleiterschalter umfasst.

Leistungsstromrichter erfordern spezielle Halbleiterschalter, also beispielsweise Transistoren, die eine ausreichend große Stromtragfähigkeit und Sperrspannung aufweisen, damit eine elektrische Leistung im Bereich ab Kilowatt mit einer möglichst geringen Anzahl an Halbleiterschaltern geschaltet werden kann. Diese Halbleiterschalter sind in der Regel in sogenannten Leistungshalbleitermodulen zusammengefasst. In Leistungshalbleitermodulen sind die Halbleiterschalter nebeneinander auf einem gemeinsamen wärmeleitfähigen Träger angeordnet. Über Bonddrähte sind die einzelnen Halbleiterschalter mit Anschlüssen verdrahtet, über welche das Leistungshalbleitermodul mit der Peripherie verschaltet wird. Zum Betrieb eines solchen Leistungshalbleitermoduls muss beispielsweise eine Schaltungsplatine angeschlossen werden, auf welcher für jeden Halbleiterschalter eine Gate-Treiberschaltung zum Schalten des Halbleiterschalters bereitgestellt ist. Des Weiteren muss das Leistungshalbleitermodul auf einem Kühlkörper montiert werden, um die im beschriebenen Träger gesammelte Wärme aus dem Leistungshalbleitermodul abzuführen.

Durch die kompakte, blockförmige Bauform und die Notwendigkeit der externen Beschaltung mit Gate-Treiberschaltungen ist es schwierig, ein Leistungshalbleitermodul an gegebene Leistungs- und Bauraumdaten anzupassen. Durch die Vielzahl an Anwendungsmöglichkeiten für moderne Umrichtertechnik ergeben sich aber je nach Anwendungsfall verschiedene Anforderungen an Leistungs- und Bauraumdaten. Dem gegenüber steht aber nur eine begrenzte Auswahl an erhältlichen Leistungshalbleitermodulen. So wird bei der begrenzten Anzahl von verfügbaren Leistungshalbleitermodulen das annähernd passende ausgewählt und verwendet werden. Ist kein passendes Leistungshalbleitermodul für eine Anwendung vorhanden, so muss auf ein nichtoptimales überdimensioniertes Leistungshalbleitermodul zurückgegriffen werden, was eine unerwünscht kostenaufwendige Lösung darstellt.

Weiterhin werden in leistungselektronischen Stellgeräten mit größerer Leistung die Schalter mit parallel geschalteten Halbleiterchips aufgebaut. Um ein nahezu synchrones Schalten der Chips zu erreichen, werden diese geometrisch eng zu einander angeordnet und in spezifischen Modulen konstruktiv zusammengefasst. Die Module verhalten sich nach außen näherungsweise wie ein Chip großer Leistung. Allerdings ist die Varianz dieser Module sehr hoch und der Integrationsgrad gering.

Daher ist heute jedes leistungselektronische Stellgerät ein Einzelstück mit sehr geringem Wiederverwendungswert bezüglich der leistungselektronischen Subkomponenten. Das führt zu langen Entwicklungszeiten und hohen Pflegeaufwänden.

Der Erfindung liegt die Aufgabe zugrunde, eine Leistungshalbleiterschaltung anzugeben, die die eingangs genannten Nachteile vermindert.

Die Aufgabe wird durch die Gegenstände der unabhängigen Patentansprüche gelöst. Vorteilhafte Weiterbildungen der Erfindung sind durch die Merkmale der abhängigen Patentansprüche gegeben.

Die erfindungsgemäße Leistungshalbleiterschaltung umfasst zwei Gleichspannungsanschlüsse, wenigstens eine Halbbrücke, die zwischen die Gleichspannungsanschlüsse geschaltet ist, wobei die Halbbrücke zwei seriell geschaltete Schalteinheiten umfasst, wobei jede Schalteinheit einen Leistungshalbleiterschalter oder mehrere parallel geschaltete Leistungshalbleiterschalter umfasst, einen Wechselspannungsanschluss für jede der Halbbrücken, eine Gate-Treiberschaltung für jede der Schalteinheiten, einen Kommutierungskondensator parallel zur Halbbrücke, eine Modulsteuerung und eine Messeinrichtung zur Bestimmung des Stroms zum Wechselspannungsanschluss. Dabei sind wenigstens die Halbbrücke, der Kommutierungskondensator und die Gate-Treiberschaltung auf einem gemeinsamen homogenen Schaltungsträger, beispielsweise einem IMS-Substrat (Insulated Metal Substrate), einer FR4-Leiterplatte oder einer DCB-Keramik (Direct Copper Bond) aufgebaut.

Vorteilhaft wird dadurch eine Leistungshalbleiterschaltung geschaffen, die allgemeiner als die bekannten Leistungshalbleitermodule einsetzbar ist. Die Leistungshalbleiterschaltung kann einzeln verwendet werden oder im Verbund mit weiteren gleichartigen Leistungshalbleiterschaltungen. Im Verbund wird beispielsweise die bereitgestellte Leistung erhöht. So kann beispielsweise ein Umrichter aus einer Mehrzahl von erfindungsgemäßen Leistungshalbleiterschaltungen aufgebaut werden. Vorteilhaft sind dabei die Gate-Treiberschaltungen bereits Teil der Leistungshalbleiterschaltung, wodurch die Schaltwege und damit parasitäre Induktivitäten verringert sind. Durch die Modulsteuerung, die auf die Messeinrichtung zur Bestimmung des Stroms zurückgreift, ist die Leistungshalbleiterschaltung im Betrieb vorteilhaft autarker als ein bekanntes Leistungshalbleitermodul.

Vorteilhafte Ausgestaltungen der erfindungsgemäßen Einrichtung gehen aus den von Anspruch 1 abhängigen Ansprüchen hervor. Dabei kann die Ausführungsform nach Anspruch 1 mit den Merkmalen eines der Unteransprüche oder vorzugsweise auch mit denen aus mehreren Unteransprüchen kombiniert werden. Demgemäß können für den Stromwandler noch zusätzlich folgende Merkmale vorgesehen werden:

- Die Leistungshalbleiterschaltung kann so aufgebaut sein, dass sie genau eine Halbbrücke umfasst. Die Leistungshalbleiterschaltung ist dann für den einphasigen Betrieb ausgelegt und kann über die Halbbrücke eine an den Gleichspannungsanschlüssen anliegende Gleichspannung in eine per PWM modulierte Wechselspannung wandeln und am Wechselspannungsanschluss ausgeben. Ein mehrphasiger Gesamtaufbau ist mit einer solchen Leistungshalbleiterschaltung erreichbar, indem beispielsweise drei Leistungshalbleiterschaltungen an den Gleichspannungsanschlüssen parallel verbunden werden und die Wechselspannungsanschlüsse der Leistungshalbleiterschaltungen als die drei Phasen einer dreiphasigen Ausgangsspannung verwendet werden. Vorteilhaft ist der Aufbau der Leistungshalbleiterschaltung mit genau einer Halbbrücke schlank und erlaubt größte Flexibilität im Aufbau komplexerer Gesamtschaltungen sowie geringsten Bauraum, wenn beispielsweise nur eine einphasige Gesamtschaltung aufgebaut werden soll. Auch wenn genau eine Halbbrücke umfasst ist, kann diese in den zwei Schalteinheiten der Halbbrücke jeweils einen einzelnen Leistungshalbleiterschalter umfassen oder jeweils eine Parallelschaltung mehrerer Leistungshalbleiterschalter.

- Die Leistungshalbleiterschaltung kann so aufgebaut sein, dass sie genau zwei Halbbrücken umfasst. Diese können parallel geschaltet sein. Dadurch ergibt sich in der Leistungshalbleiterschaltung eine Vollbrücke. Diese kann beispielsweise beim Aufbau eines DC/DC-Wandlers eingesetzt werden, aber auch für andere elektrische Wandler.

- Die Leistungshalbleiterschaltung kann so aufgebaut sein, dass sie genau drei Halbbrücken umfasst. Diese können parallel geschaltet sein. Die Halbbrücken sind dabei wiederum auf der gemeinsamen Leiterplatte angeordnet. Die Leistungshalbleiterschaltung ist dann für den dreiphasigen Betrieb ausgelegt und kann über die Halbbrücken eine an den Gleichspannungsanschlüssen anliegende Gleichspannung in eine per PWM modulierte dreiphasige Wechselspannung wandeln und an den drei Wechselspannungsanschlüssen ausgeben. Vorteilhaft ist der Aufbau der Leistungshalbleiterschaltung mit genau drei Halbbrücken gegenüber der einphasigen Leistungshalbleiterschaltung bauraumoptimiert für dreiphasige Gesamtschaltungen und ermöglicht somit dreiphasige Gesamtschaltungen mit geringerem Volumen. Gleichzeitig ist die Ansteuerung der Schalteinheiten vereinfacht, da die Modulsteuerung ohne Kommunikation nach außen die Phasenlage der Pulsweitenmodulation für die dreiphasige Ausgangsspannung festlegen kann.

- Der Kommutierungskondensator kann eine Kapazität von höchstens 10 μF aufweisen. Dadurch kann ein vergleichsweise kleiner Kondensator verwendet werden. Zweck des Kommutierungskondensators ist die Bereitstellung und Aufbau einer Kommutierungszelle mit der Halbbrücke oder Halbbrücken der Leistungshalbleiterschaltung. In einer Gesamtschaltung, die beispielsweise einen Umrichter darstellt, kann daher ein optimaler Kondensator für den Aufbau eines Zwischenkreises gewählt werden; durch den Aufbau der Leistungshalbleiterschaltung oder Leistungshalbleiterschaltungen ist weiterhin eine optimale Kommutierung mit geringen parasitären Induktivitäten durch kurze Stromwege bei den Schaltvorgängen gewährleistet. Die maximale Kapazität des Kommutierungskondensators ist dabei an die maximale Betriebsspannung, d.h. die Sperrfähigkeit der eingesetzten Leistungshalbleiterschalter gekoppelt.

- Die Leistungshalbleiterschaltung kann eine Einrichtung zur Messung der Spannung des Kommutierungskondensators aufweisen, wobei diese Einrichtung zweckmäßig mit auf der gemeinsamen Leiterplatte integriert ist. Durch die Messung der Spannung steht der Modulsteuerung ein weiterer Eingangswert zur Verfügung, der zur Steuerung der Leistungshalbleiterschaltung verwendet werden kann. Die Modulsteuerung wird dadurch autarker und flexibler und kann beispielsweise besser auf fehlerhafte Betriebssituationen wie fehlende oder zu hohe Eingangsspannung reagieren.

- Die Leistungshalbleiterschaltung kann eine Einrichtung zur Messung der Temperatur umfassen, die zweckmäßig mit auf der gemeinsamen Leiterplatte integriert ist. Die Einrichtung zur Messung der Temperatur kann beispielsweise einen NTC-Messwiderstand wie ein KTY oder ein Platin-Messelement, beispielsweise ein Pt100- oder Pt1000-Messfühler umfassen. Vorteilhaft wird dadurch die Erkennung von fehlerhaften Zuständen der Leistungshalbleiterschaltung oder auch der Umgebung der Leistungshalbleiterschaltung ermöglicht. Die Modulsteuerung wird dadurch autarker und kann beispielsweise Schaden an den Leistungshalbleiterschaltern verringern oder vermeiden, wenn zu hohe Temperaturbelastungen auftreten. Weiterhin wird es möglich, dass die Modulsteuerung eine Lebensdauerabschätzung ermitteln und ausgeben kann, indem beispielsweise Temperaturbelastungen über die Betriebszeiten hinweg aufsummiert werden und anhand der summierten Temperaturbelastungen auf eine Restlebensdauer der Leistungshalbleiterschalter geschlossen wird. Vorteilhaft ist es, wenn die Einrichtung zur Messung der Temperatur in der unmittelbaren Umgebung der Halbbrücke, insbesondere zwischen den Schalteinheiten der Halbbrücke, angeordnet ist, so dass der Wärmeeintrag der Leistungshalbleiterschalter schnell und direkt gemessen werden kann.

- Die Leistungshalbleiterschaltung kann eine Entkopplungs-Induktivität zwischen dem Mittelpunkt einer oder aller Halbbrücken und dem dazugehörigen Wechselspannungsanschluss aufweisen. Damit wird erreicht, dass eine Parallelschaltung mehrerer der Leistungshalbleiterschaltungen ermöglicht wird. Die Größe der Entkopplungs-Induktivität ist abhängig von dem Jitter der Ansteuerung, der Zwischenkreisspannung, dem Laststrom und der zulässigen dynamischen Stromasymmetrie. Beträgt beispielsweise der Jitter 50ns, die Zwischenkreisspannung 480 V, der Laststrom 35 A, Asymmetrie 5%, ist eine Entkopplungs-Induktivität von $20\,\mu H$ zweckmäßig. Die Größe der Entkopplungs-Induktivität beträgt bevorzugt zwischen $2\,\mu H$ und $50\,\mu H$. Damit wird Strom- und Spannungsbereich von 20 A bis 200 A sowie zwischen 380 V und 690 V abgedeckt.

- Die Leistungshalbleiterschaltung kann einen zweiten Wechselspannungsanschluss aufweisen. Mit diesem kann beispielsweise eine Querverbindung zu einem Wechselspannungsanschluss einer weiteren Leistungshalbleiterschaltung geschaffen werden. Insbesondere kann die Leistungshalbleiterschaltung einen Filterkondensator zwischen dem Wechselspannungsanschluss und dem zweiten Wechselspannungsanschluss aufweisen. Damit kann eine Filterung der Ausgangsspannung vorteilhaft sogar im Verbund mit mehreren der Leistungshalbleiterschaltungen erfolgen.

- Auch bei einer Leistungshalbleiterschaltung mit zwei oder drei Halbbrücken können zwei, insbesondere genau zwei Wechselspannungsanschlüsse vorliegen. Beispielsweise kann die Leistungshalbleiterschaltung als Phasenbaustein verwendet werden, bei dem die drei Halbbrücken synchron angesteuert werden und so nur einer Phase im Gesamtaufbau entsprechen. Dann kann auch ein zweiter Wechselspannungsanschluss für eine Querverbindung mehrerer Leistungshalbleiterschaltungen verwendet werden.

- Die Leistungshalbleiterschaltung kann einen dritten Gleichspannungsanschluss aufweisen. In diesem kann ein Anschluss an einen Neutralleiter, ein Erdpotential oder ein Mittelpunkts-Potential eines extern angeordneten Zwischenkreises realisiert werden. Dieses Potential kann vorteilhaft in der Leistungshalbleiterschaltung mitgenutzt werden, um beispielsweise eine veränderte Pulsweiten-Modulation durchzuführen, also beispielsweise eine Betriebsform eines Mehrstufenwandlers. In diesem Fall ist es vorteilhaft, wenn der Kommutierungskondensator in Serie zu einem zweiten Kommutierungskondensator geschaltet ist wobei der Potentialpunkt zwischen den beiden Kommutierungskondensatoren mit dem dritten Gleichspannungsanschluss verbunden ist. Wiederum können die Kommutierungskondensatoren mit der Halbbrücke eine Kommutierungszelle bilden.

- Der dritte Gleichspannungsanschluss kann über einen bipolaren Schalter mit dem Mittelpunkt der Halbbrücke verbunden sein. Damit kann das durch den dritten Gleichspannungsanschluss vorgegebene Potential für die Wechselspannung mitverwendet werden.

- Die Leistungshalbleiterschaltung kann so gestaltet sein, dass die zwei oder drei Gleichspannungsanschlüsse sowie die ein, zwei oder drei Wechselspannungsanschlüsse die einzigen vorhandenen Lastanschlüsse sind. Die Leistungshalbleiterschaltung bildet somit ein abgeschlossenes Bauteil ähnlich der Leistungshalbleitermodule mit deutlich erweiterter Funktion.

- Die Leistungshalbleiterschalter können beispielsweise durch IGBTs oder MOSFETs gebildet sein. Die Leistungshalbleiterschalter können durch Wide-Bandgap-Halbleiterschalter, insbesondere GaN-Schalter oder SiC-Schalter, gebildet sein. IGBTs und MOSFETs sind für die Anwendung bekannt. GaN-Schalter, beispielsweise als HEMT oder Kaskode, sind bisher nicht verbreitet, bieten aber deutliche Vorteile bezüglich des verwendbaren Bereichs der Schaltfrequenz und hinsichtlich der Verlustleistung. Im Gegensatz zu rein Silizium-basierten Halbleiterschaltern lassen sich Wide-Bandgap-Halbleiterschalter mit einer höheren Schaltfrequenz schalten.

- Die Modulsteuerung kann eine serielle Schnittstelle zur Kommunikation aufweisen. Über die Schnittstelle ist beispielsweise eine Kommunikation mit einem Sollwertgeber möglich. Die Schnittstelle nimmt in Sollwertrichtung Ansteuerbefehle entgegen. Dabei kann die Kommunikation über eine Ansteuerung mit einem einzelnen Signalwert hinausgehen, da über die Schnittstelle beispielsweise auch mehrere verschiedene Steuerwerte übertragbar sind, wie beispielsweise Frequenz und Phasenlage einer zu erzeugenden Wechselspannung. Auch kann die Schnittstelle bidirektional gestaltet sein, sodass die Modulsteuerung auch Werte zurücksenden kann. Beispielsweise kann die Modulsteuerung Werte für den Strom, Spannung, Temperatur und Informationen über das Schaltverhalten wie beispielsweise Schaltzeiten zurücksenden. Die Modulsteuerung umfasst dazu bevorzugt einen Mikroprozessor und einen Speicher. Weiterhin ermöglicht die Schnittstelle auch eine Kommunikation von mehreren der Leistungshalbleiterschaltungen untereinander.

- Die Modulsteuerung kann so ausgestaltet sein, dass sie eine Pulsweiten-Modulation der Halbbrücke mit einer von außen über die Schnittstelle an die Modulsteuerung vorgebbaren Phase und/oder Ausgangsfrequenz durchführen kann. Die Leistungshalbleiterschaltung agiert damit als intelligentes Bauelement, das keine exakte elektrische Ansteuerung benötigt, sondern mit abstrahierten Sollwerten angesteuert werden kann.

- Die Modulsteuerung kann ausgestaltet sein, eine Frequenz von wenigstens 2 kHz, wenigstens 10 kHz oder wenigstens 30 kHz zum Schalten der Schalteinheiten zu verwenden.

- Es ist zweckmäßig, wenn die Lastanschlüsse ebenfalls auf der gemeinsamen Leiterplatte angeordnet sind. Ebenso ist es zweckmäßig, wenn die Modulsteuerung und die Messeinrichtung zur Bestimmung des Stroms auf der gemeinsamen Leiterplatte angeordnet sind.

- Der Kommutierungskondensator kann auch aus mehreren, beispielsweise in Serie oder parallel geschalteten Kondensatoren, bestehen. Die Kapazität des Kommutierungskondensators entspricht dann der Gesamtkapazität dieser Kondensatoren. Das ist vorteilhaft, wenn es keinen Kondensator gibt, der für den geforderten Strom und/oder die geforderte Spannung spezifiziert ist.

- Die Steuerleitungen zwischen einer Gate-Treiberschaltung und dem oder den Leistungshalbleiterschaltern der zugeordneten Schalteinheit können durch eine jeweilige Leiterbahn der gemeinsamen Leiterplatte gebildet sein. Hierdurch ist es anders als bei einem kompakten Leistungshalbleitermodul nicht nötig, die Gate-Treiberschaltung durch Bonding mit den Leistungshalbleiterschaltern zu verschalten. Dies verringert zusätzlich die parasitäre Induktivität, durch welche die maximal mögliche Schaltfrequenz beeinträchtigt wird.

- Die Halbleiterschalter können jeweils über eine Lotschicht drahtfrei mit den Leiterbahnen mechanisch und elektrisch verbunden sein. Mit anderen Worten sind die Halbleiterschalter nicht beispielsweise als diskretes Bauteil mit Pins ausgestaltet, die in die Leiterplatte gesteckt und verlötet sind. Stattdessen liegt jeder Halbleiterschalter auf den Leiterbahnen auf und ist an diesen über eine Lotschicht, das heißt eine Schicht aus Lötzinn, angelötet. Hierdurch ist die Anbindung geometrisch besonders kurz. Hierdurch wird eine geringe parasitäre Induktivität erreicht. Damit lässt sich jeder Halbleiterschalter mit einer größeren Schaltfrequenz schalten, ohne dass es hierdurch zur Induktion von einer Überspannung kommt.

- Die gemeinsame Leiterplatte kann ein Substrat aus Metall aufweisen. Sie kann beispielsweise ein IMS (Insulated Metal Substrate) sein. Hierdurch ergibt sich der Vorteil, dass trotz der hohen Schaltfrequenzen die Halbleiterschalter über das Metall entwärmt werden können, so dass sowohl die Leiterbahnen als auch die Halbleiterschalter mit ein und derselben Kühltechnologie durch Abführen der Verlustwärme über das Metall entwärmt werden können. Eine preisgünstigere Variante sieht eine Leiterplatte auf der Grundlage eines Kunststoffes vor, beispielsweise auf der Grundlage von Epoxidharz oder Glasfasermatten, die in Epoxidharz getränkt sind. Durch die Verwendung eines Kunststoffes ist die Kriechstromfestigkeit besonders hoch. Zudem ergibt sich eine geringere parasitäre Kapazität als bei der Verwendung eines Metallsubstrats, was insbesondere bei einer hohen Schaltfrequenz einen geringeren Leckstrom verursacht.

Im Folgenden ist ein Ausführungsbeispiel der Erfindung beschrieben. Hierzu zeigen schematisch:

Figur 1 ein Schaltbild für eine Ausführungsform der erfindungsgemäßen Leistungshalbleiterschaltung,
Figur 2 den Aufbau Leistungshalbleiterschaltung nach Figur 1,
Figur 3 ein Schaltbild für eine zweite Ausführungsform der erfindungsgemäßen Leistungshalbleiterschaltung, und
Figur 4 ein Schaltbild für eine dritte Ausführungsform der erfindungsgemäßen Leistungshalbleiterschaltung.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

In den Figuren sind funktionsgleiche Elemente jeweils mit denselben Bezugszeichen versehen.

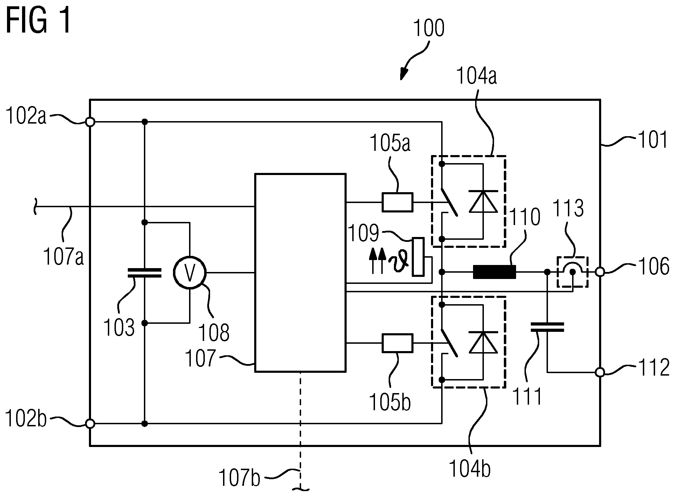

Figur 1 zeigt ein Schaltbild einer ersten Ausführungsform der erfindungsgemäßen Leistungshalbleiterschaltung. Das erste Modul 100 umfasst eine Leiterplatte 101. Die Leiterplatte 101 ist in diesem Ausführungsbeispiel ein IMS-Substrat, kann aber auch ein FR4 Material oder eine DCB Keramik sein. Das erste Modul 100 umfasst als Lastanschlüsse zur Verbindung mit weiteren leistungselektronischen Komponenten zwei Gleichspannungs-Anschlüsse 102a, 102b sowie einen Wechselspannungsanschluss 106 und einen weiteren Wechselspannungsanschluss 112 auf. Diese sind in Figur 1 am Rand der Leiterplatte 101 liegend gezeigt, müssen aber in der realen Umsetzung nicht am Rand liegen oder an gegenüber liegenden Seiten der Leiterplatte 101.

Auf der Leiterplatte 101 sind als weitere Elemente des ersten Moduls 100 ein Kommutierungskondensator 103, ein Spannungswandler 108, eine Modul-Steuerung 107 in Form eines Mikroprozessors, eine Halbbrücke mit zwei IGBTs 104, 104b sowie zwei zugehörige Gate-Treiberschaltungen 105a, 105b, ein Temperaturfühler 109, eine Filterinduktivität 110 und ein Filterkondensator 111 sowie ein Stromwandler 113 angeordnet.

Der Kommutierungskondensator 103 ist dabei zwischen die beiden Gleichspannungs-Anschlüsse 102a, 102b geschaltet. Der Kommutierungskondensator 103 kann in einem konkreten Aufbau auch aus mehreren, beispielsweise in Serie und/oder parallel geschalteten Kondensator-Bauteilen, bestehen. Im vorliegenden Beispiel hat der Kommutierungskondensator 103 eine Kapazität von 36 nF.

Die Kapazität C des Kommutierungskondensators 103 lässt sich aus dem maximalen Laststrom I, der im Kommutierungskreis wirksamen Kommutierungs-Induktivität $L_k$, der Spannung $U_{CE}$ und der Zwischenkreisspannung $U_{DC}$ wie folgt bestimmen:

$$ C = \frac{I^2\, L_k}{(U_{CE} - U_{DC})^2} $$

Beträgt der maximale Strom I = 200A, die Induktivität $L_k$ = 40nH, die Kollektor-Emitter-Spannung $U_{CE}$ = 900V und die Zwischenkreisspannung $U_{DC}$ = 690V, dann ergibt sich daraus eine Kapazität C von 36nF.

Parallel zum Kommutierungskondensator 103 ist der Spannungswandler 108 geschaltet. Der Spannungswandler 108 ist mit der Modul-Steuerung 107 verbunden und ermöglicht der Modul-Steuerung 107, den Ladezustand des Kommutierungskondensators 103 bei der Ansteuerung der Halbbrücke zu berücksichtigen.

Die Modul-Steuerung 107 weist im vorliegenden Ausführungsbeispiel zwei Schnittstellen auf. Eine serielle Schnittstelle 107a dient dem Datenaustausch mit einer externen, übergeordneten Steuerung. Dieser Datenaustausch kann beispielsweise die Vergabe von Sollwerten von der übergeordneten Steuerung an die Modul-Steuerung 107 sein. Ein solcher Sollwert kann beispielsweise eine Phasenlage oder Amplitude einer auszugebenden Wechselspannung sein. Der Sollwert ist dabei abstrahiert, d.h. er ist unabhängig von der konkreten Ansteuerung, die für die IGBTs 104a, 104b der Halbbrücke nötig ist, um die Sollwerte auch zu erreichen. Die Umsetzung der abstrahierten Sollwerte in eine konkrete Ansteuerung der IGBTs 104a, 104b, beispielsweise in Form einer geeigneten Pulsweiten-Modulation wird von der Modul-Steuerung 107 vorgenommen.

Eine weitere Schnittstelle 107b dient der Verbindung mit einer Modul-Steuerung weiterer Schaltungen, die wie das erste Modul 100 aufgebaut sind. Über die weitere Schnittstelle 107b können die Modul-Steuerungen 107 beispielsweise Betriebsdaten austauschen und so eine interne Organisation der Spannungswandlung vornehmen, die unabhängig von der übergeordneten Steuerung abläuft.

Die Modul-Steuerung 107 ist weiterhin mit den Gate-Treiberschaltungen 105a, 105b verbunden und steuert diese an, um die IGBTs 104a, 104b zu schalten, beispielsweise in einem Schaltmuster einer Pulsweiten-Modulation. Die Gate-Treiberschaltungen 104a, 104b sind dazu über geeignete, möglichst kurze Steuerleitungen mit den Gate-Kontakten der IGBTs 104a, 104b verbunden.

Die IGBTs 104a, 104b sind gleichsinnig in Serie geschaltet und bilden somit eine Halbbrücke aus. Die Halbbrücke ist zwischen die Gleichspannungs-Anschlüsse 102a, 102b und somit parallel zum Kommutierungskondensator 103 geschaltet. Der Mittelpunkt der Halbbrücke ist mit der Filterinduktivität 110 verbunden, wobei der zweite Anschluss der Filterinduktivität 110 mit dem Wechselspannungsanschluss 106 verbunden ist. Im Leitungs-Bereich zwischen Wechselspannungsanschluss 106 und Filterinduktivität 110 ist ein Stromwandler 113 angeordnet. Der zweite Anschluss der Filterinduktivität 110 ist weiterhin über den Filterkondensator 111 mit dem weiteren Wechselspannungsanschluss 112 verbunden.

Im Bereich zwischen den beiden IGBTs 104a, 104b, d.h. zwischen ihrer tatsächlichen Position auf der Leiterplatte 101 ist ein Temperaturfühler 109, beispielsweise in Form eines Platinwiderstands angeordnet. Der Temperaturfühler 109 ist ebenso wie der Stromwandler 113 mit der Modul-Steuerung 107 verbunden. Die Modul-Steuerung verfügt somit über Werte für den Ausgangsstrom, die Eingangsspannung und die Temperatur im Bereich der Halbbrücke, um eine geeignete Steuerung der IGBNTs 104a, 104b vorzunehmen und ggfs. Meldungen über Fehlerfälle über die serielle Schnittstelle 107a auszugeben.

Der Filter mit der Filterinduktivität 110 dient auch zur Begrenzung von Spannungsänderungen dU/dt und weiterhin zur Reduzierung von Oberschwingungen bis hin zum reinen Sinusverlauf der Ausgangsspannung. Das ist besonders von Vorteil, wenn Wide-Bandgap-Schalter wie beispielsweise GaN-Schalter mit sehr hohen Schaltfrequenzen, beispielsweise im MHz-Bereich, eingesetzt werden und dadurch die Filterelemente sehr klein gestaltet werden können und die Integration im Modul 100 einfach zu bewerkstelligen ist.

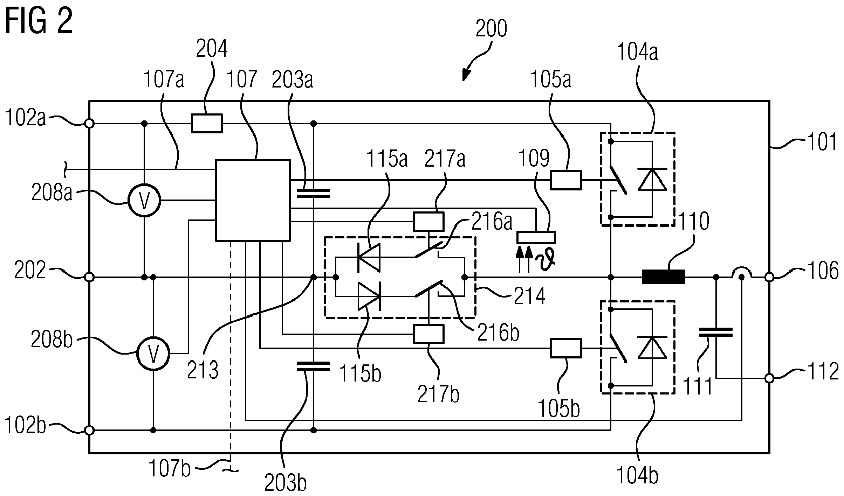

Figur 2 zeigt ein Schaltbild einer zweiten Ausführungsform der erfindungsgemäßen Leistungshalbleiterschaltung. Das zweite Modul 200 umfasst weitgehend die Komponenten des ersten Moduls 100, wobei einige Elemente ersetzt oder ergänzt sind.

Das zweite Modul 200 weist einen dritten Gleichspannungsanschluss 202 auf. Über den dritten Gleichspannungsanschluss 202 kann beispielsweise ein Anschluss an einen Neutralleiter, ein Erdpotential oder ein Mittelpunkts-Potential eines extern angeordneten Zwischenkreises realisiert werden. An der Stelle des Spannungswandlers 108 sind nun zwei Spannungswandler 208a, 208b vorgesehen, die die Spannung zwischen je einem der Gleichspannungsanschlüsse 102a, 102b und dem dritten Gleichspannungsanschluss 202 aufnehmen und an die Modul-Steuerung 107 weitergeben. Der einzelne Kommutierungskondensator 103 ist ersetzt durch eine Serie aus einem ersten und zweiten Kommutierungskondensator 203a, 203b, die zwischen die Gleichspannungsanschlüsse 102a, 102b geschaltet sind. Der Potentialpunkt 213 zwischen den beiden Kommutierungskondensatoren 203a, 203b ist mit dem dritten Gleichspannungsanschluss 202 verbunden.

Zwischen dem Potentialpunkt 213 und dem Mittelpunkt der Halbbrücke ist ein bipolarer Schalter 214 geschaltet. Der bipolare Schalter 214 umfasst eine Parallelschaltung zweier Serienschaltungen, wobei die Serienschaltungen je eine Diode 215a, 215b und je einen IGBT 216a, 216b aufweisen. Für die beiden IGBTs 216a, 216b ist je eine Gate-Treiberschaltung 217a, 217b vorgesehen.

Schließlich ist in der Verbindung zwischen dem ersten Kommutierungskondensator 203a und dem Gleichspannungsanschluss 102a ein Dämpfungswiderstand 204 vorgesehen. Dieser dient der Dämpfung von Schwingungen, die sich im Schwingkreis aus den Kommutierungskondensatoren 203a, 203b und außen angeschlossenen Zwischenkreiskondensatoren sowie den Leitungsinduktivitäten ergeben. Der Dämpfungswiderstand 204 kann auch zwischen den Kommutierungskondensatoren 203a, 203b oder zwischen dem zweiten Kommutierungskondensator 203b und dem Gleichspannungsanschluss 102b angeordnet sein.

Die weiteren Elemente des ersten Moduls 100 sind unverändert auch im zweiten Modul 200 vorhanden.

Das zweite Modul 200 erlaubt somit den Betrieb nach Art eines Dreipunktwechselrichters, bei dem auch ein mittleres Spannungsniveau des Zwischenkreises bei der Pulsweiten-Modulation mitverwendet wird, um eine verbesserte Modulation der Wechselspannung und damit einer Verringerung der nötigen Filter zu erreichen. Die Modul-Steuerung 107 ist daher dafür ausgelegt, neben den IGBTs 104a, 104b der Halbbrücke auch die IGBTs 216a, 216b des bipolaren Schalters 214 über die jeweiligen Gate-Treiberschaltungen 105a, 105b, 217a, 217b anzusteuern. Dazu werden Sollwerte und Messwerte wie im ersten Modul 100 aufgenommen und verarbeitet, wobei bedingt durch den dritten Gleichspannungsanschluss 202 ein zusätzlicher Spannungswert zur Verfügung steht.

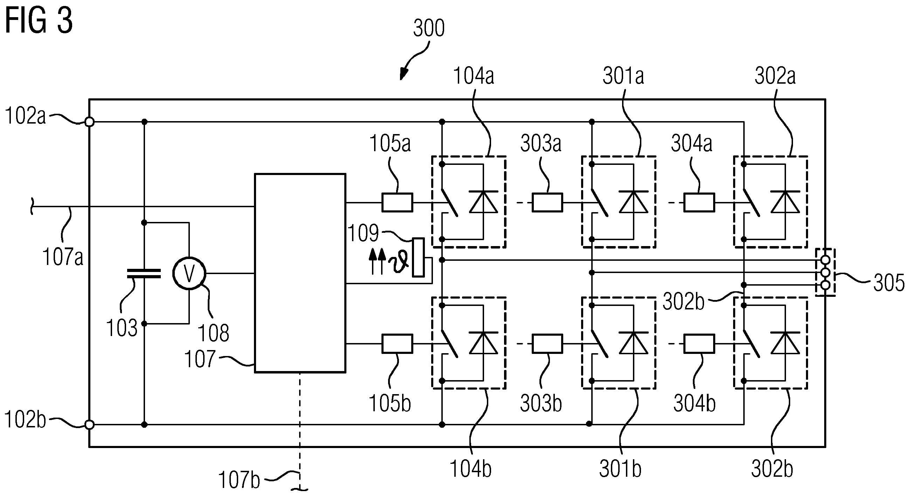

Das erste und zweite Modul 100, 200 sind einphasige Schaltungen. Figur 3 zeigt ein Schaltbild einer dritten Ausführungsform der erfindungsgemäßen Leistungshalbleiterschaltung. Die dritte Ausführungsform ist dabei für dreiphasige Anwendungen direkt ausgelegt und optimiert. Das dritte Modul 300 umfasst dabei wiederum einige Elemente des ersten Moduls 100, die wiederum mit gleichen Bezugszeichen versehen sind. Daneben umfasst das dritte Modul 300 zusätzliche Elemente und weitere Elemente des ersten Moduls 100 sind im dritten Modul 300 nicht vorhanden.

Das dritte Modul 300 umfasst zwei weitere Halbbrücken, die der Halbbrücke, die schon im ersten Modul 100 vorhanden war, parallel geschaltet sind. Die zweite Halbbrücke umfasst zwei in Serie geschaltete IGBTs 301a, 301b und die dritte Halbbrücke umfasst zwei in Serie geschaltete IGBTs 302a, 302b. Die zusätzlichen IGBTs 301a, 301b, 302a, 302b weisen Steuerleitungen zu Gate-Treiberschaltungen 303a, 303b, 304a, 304b auf, über die sie von der Modul-Steuerung 107 angesteuert werden.

Das dritte Modul 300 umfasst drei Wechselspannungsanschlüsse 305, von denen ein erster mit dem Mittelpunkt der ersten Halbbrücke, ein zweiter mit dem Mittelpunkt der zweiten Halbbrücke und ein dritter mit dem Mittelpunkt der dritten Halbbrücke verbunden ist. Die Filterinduktivität 110 und der Filterkondensator 111 sind im dritten Modul 300 gemäß dieser Ausführungsform nicht vorhanden, können aber in andere Ausführungsformen vorhanden sein, um an den Wechselspannungsanschlüssen eine gefilterte Wechselspannung auszugeben. Im Strompfad zu jedem der Wechselspannungsanschlüsse 305 ist ein Stromwandler vorgesehen, der aber aus Gründen der Übersicht in Figur 3 nicht gezeigt ist.

Das dritte Modul erlaubt also die Ausgabe beispielsweise einer dreiphasigen Wechselspannung, wobei eine übergeordnete Steuerung wiederum abstrahierte Sollwerte zu der Wechselspannung wie Phasenlage, Frequenz und/oder Amplitude vorgeben kann. Die Modul-Steuerung 107 kann auch so ausgelegt sein, dass die drei erzeugten einzelnen Wechselspannungssignale nicht um 120° phasenversetzt zueinander sind, sondern mit einem frei wählbaren Phasenversatz erzeugt werden. Beispielsweise können alle drei Wechselspannungssignale phasengleich erzeugt werden.

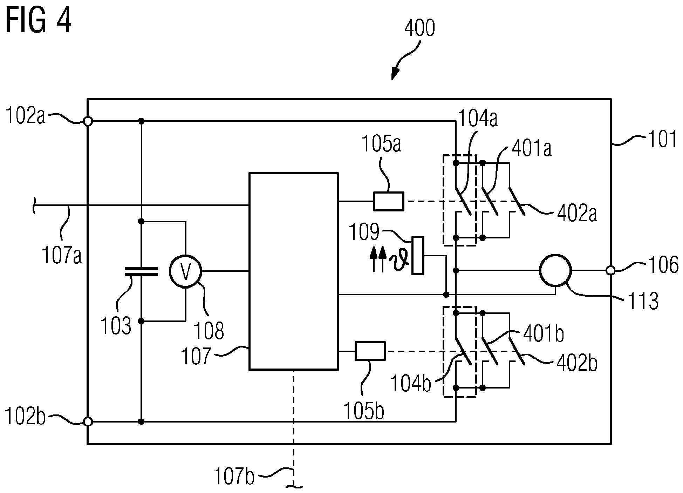

Figur 4 zeigt ein Schaltbild einer vierten Ausführungsform der erfindungsgemäßen Leistungshalbleiterschaltung. Die vierte Ausführungsform ist dabei wiederum für einphasige Anwendungen ausgelegt, wobei wie bei den anderen einphasigen Modulen 100, 200 eine Zusammenschaltung mehrerer der Module 100, 200 möglich ist, um einen dreiphasigen Aufbau bereitzustellen. Das vierte Modul 400 gemäß Figur 4 umfasst dabei einige Elemente des ersten Moduls 100, die wiederum mit gleichen Bezugszeichen versehen sind. Daneben umfasst das vierte Modul 400 zusätzliche Elemente. Einige Elemente des ersten Moduls 100 sind im vierten Modul 400 nicht vorhanden.

Im vierten Modul 400 sind parallel zum IGBT 104a und parallel zueinander zwei weitere IGBTs 401a, 402a vorgesehen. Die Ansteuerung der zusätzlichen IGBTs 401a, 402a erfolgt über die Gate-Treiberschaltung 105a, die bereits für den IGBT 104a aus dem ersten Modul 100 vorhanden ist. In analoger Weise sind parallel zum IGBT 104b zwei weitere IGBTs 401b, 402b vorhanden. Die Ansteuerung der zusätzlichen IGBTs 401b, 402b erfolgt über die Gate-Treiberschaltung 105b. Die IGBTs 104a...b, 401a...b, 402a...b sind in Figur 4 für bessere Übersichtlichkeit ohne ihre interne Diode dargestellt.

Im Gegensatz zum ersten Modul 100 umfasst das vierte Modul 400 keine Filterinduktivität 110 und keinen Filterkondensator 111 sowie keinen weiteren Wechselspannungsanschluss 112. Es ist möglich, dass das vierte Modul 400 mit einer Leiterplatte 101 aufgebaut wird, die vorgefertigte Bestückungsplätze für die Filterinduktivität 110 und den Filterkondensator 111 aufweist. In diesem Fall ist der Bestückungsplatz für die Filterinduktivität 110 mit einem passenden Bauteil elektrisch durchverbunden und der Bestückungsplatz für den Filterkondensator 111 nicht belegt und somit elektrisch durchtrennt. Ebenso ist es möglich, dass der weitere Wechselspannungsanschluss 112 zwar auf der Leiterplatte 101 vorhanden ist, beispielsweise als Schraubanschluss, aber bei fehlendem Bauteil für den Filterkondensator 111 keine elektrische Funktion hat.

Durch die Parallelschaltung der zusätzlichen IGBTs 401a...b, 402a...b wird der Leistungsbereich der Schaltung entsprechend der Anzahl der zusätzlichen Leistungshalbleiter erweitert. Auch hier können Bestückungsplätze für die Leistungshalbleiter vorgesehen sein, die abhängig von der gewünschten Leistung des vierten Moduls 400 bestückt werden oder offengelassen werden.

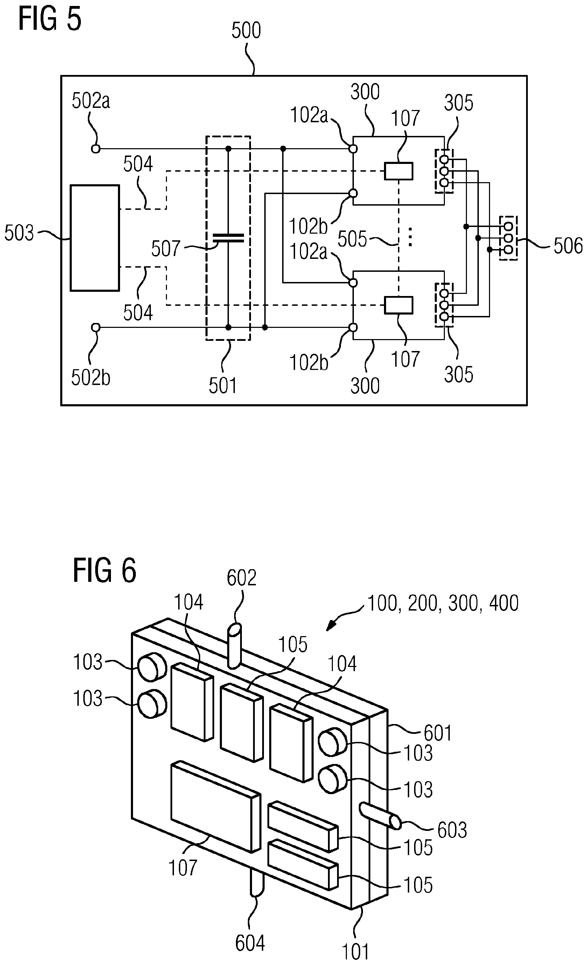

Figur 5 zeigt die Anordnung einer Mehrzahl von Modulen 300 zu einem Stromrichter 500. Der Stromrichter 500 umfasst erste Anschlüsse 502a, 502b für den Anschluss an ein Gleichspannungsnetzwerk, das beispielsweise eine Gleichspannungsquelle, aber auch eine Last sein kann. Zwischen die ersten Anschlüsse 502a, 502b ist ein Zwischenkreis 501 mit einem Zwischenkreiskondensator 507 geschaltet. Der Zwischenkreiskondensator 507 ist hinsichtlich seiner Kapazität für den gesamten Stromrichter ausgelegt und weist daher eine höhere Kapazität auf als die Kommutierungskondensatoren 103 der einzelnen Module 300.

Der Stromrichter 500 umfasst eine Mehrzahl von Modulen 300, von denen in Figur 5 zwei dargestellt sind. Tatsächlich kann der Stromrichter 500 jede Anzahl von Modulen 300 umfassen, wobei zweckmäßige Anzahlen zwei, drei, vier, fünf oder sechs Module 300 sind. Die Module 300 sind parallel zueinander mit dem Zwischenkreis verbunden, d.h. die ersten Gleichspannungsanschlüsse 102a mit dem ersten Anschluss 502a und die zweiten Gleichspannungsanschlüsse 102b mit dem zweiten Anschluss 502b.

Der Stromrichter 500 umfasst weiterhin eine Stromrichter-Steuerung 503, die über Steuerleitungen 504 mit den Modul-Steuerungen 107 verbunden ist. Die Modul-Steuerungen 107 sind untereinander wiederum durch Querverbindungen 505 verbunden. Dabei sind die Querverbindungen 505 optional, da auch ein sternförmiges Anschlussschema möglich ist, bei dem nur die Steuerleitungen 504 verwendet werden. Eine weitere Alternative besteht darin, dass nur eine Steuerleitung 504 verwendet wird und das damit angesteuerte Modul 300 die Steuerbefehle über die Querverbindungen weitergibt.

Die Wechselspannungsanschlüsse 305 der Module 300 sind zusammengeschlossen zu einem zweiten, dreiphasigen Anschluss 506. Mit anderen Worten sind die Module 300 also parallel geschaltet. Die Leistungshalbleiter-Schalter innerhalb der einzelnen Module 300 werden dabei synchron geschaltet.

Insgesamt bilden die zusammengeschalteten Module 300 zusammen mit dem Zwischenkreis 501 und der Stromrichter-Steuerung 503 einen Stromrichter 500 aus, der als Gleichrichter oder als Wechselrichter arbeiten kann. Seine Gesamtleistung ergibt sich aus den summierten Leistungsdaten der Module 300. Stromrichter anderer Leistungsklassen lassen sich aus einer veränderten Anzahl von Modulen 300 aufbauen oder unter Verwendung anderer Typen von Modul 100, 200, 300, 400. So können beispielsweise auch DC/DC-Wandler aufgebaut werden unter Verwendung von Modulen 100, 200, 400.

Figur 6 zeigt einen schematisierten Aufbau eines Moduls 100, 200, 300, 400.

Das Modul 100, 200, 300, 400 umfasst eine Leiterplatte 101, auf der die elektronischen Bauteil angeordnet sind. Auf der Leiterplatte 101 sind Leiterbahnen aus Kupfer oder Aluminium angeordnet, durch die eine Verbindung der Bauteile bereitgestellt wird. Die Leiterbahnen sind in Figur 6 nicht dargestellt.

Die Leiterplatte 101 ist als IMS mit einem metallischen Substrat und einer elektrisch isolierenden Schicht zwischen dem Substrat und den Leiterbahnen ausgestaltet. Das Substrat kann beispielsweise aus Aluminium oder Kupfer gebildet sein. Die Isolierschicht kann beispielsweise eine Keramikschicht oder ein Lack sein.

In einem ersten Bereich der Leiterplatte 101 sind Kommutierungskondensatoren 103, Leistungshalbleiter 104 und Gatetreiber-Schaltungen 105 für die Leistungshalbleiter 104 angeordnet. Jeder Halbleiterschalter 104 kann als diskreter Elektronikbaustein, beispielsweise als SMD-Baustein, ausgestaltet sein, bei welchem die Halbleiterschichten in einem Gehäuse angeordnet sind. Die Elektronikbausteine sind mittels einer Lotschicht auf der Leiterplatte 101 verankert, wobei die Lotschicht durch Lötzinn gebildet sein kann. Die Lotschicht kann beispielsweise mittels eines Schwelllötverfahrens an den Leiterbahnen oder an den Kontaktflächen der Elektronikbausteine angeordnet worden sein, und der Elektronikbaustein mit der Leiterplatte 101 verlötet worden sein.

Bei den Gatetreiber-Schaltungen 105 kann es sich jeweils um eine Schaltung handeln, wie sie an sich aus dem Stand der Technik als Gate-Treiber bekannt ist. Durch die Gatetreiber-Schaltungen wird beim Schalten des jeweiligen Halbleiterschalters 104 eine Gate-Kapazität des Gates umgeladen. Durch das Verschalten von diskreten Halbleiterschaltern 104 mit Gatetreiber-Schaltungen auf einer gemeinsamen Leiterplatte 101 können somit Treiber und Halbleiterschalter niederinduktiver angebunden werden. Die Stromtragfähigkeit lässt sich über die Anzahl der parallelisierten Halbleiterschalter 104 anwendungsbezogen einstellen.

Das Modul 100, 200, 300, 400 der Figur 6 umfasst weiterhin ein Kommunikationsinterface 604, Anschlüsse 603 für die Gleichspannung und Anschlüsse für die Wechselspannung 602.

Auf der von den elektronischen Komponenten abgewandten Seite ist ein Kühlinterface 601 vorgesehen.

**Patentansprüche**

1. Leistungshalbleiterschaltung (100, 200, 300, 400) mit

    - zwei Gleichspannungsanschlüssen (102a, 102b),
    - wenigstens einer Halbbrücke, die zwischen die Gleichspannungsanschlüsse (102a, 102b) geschaltet ist, wobei die Halbbrücke zwei seriell geschaltete Schalteinheiten (104a, 104b, 301a, 301b, 302a, 302b) umfasst, wobei jede Schalteinheit einen Leistungshalbleiterschalter (104a, 104b, 301a, 301b, 302a, 302b) oder mehrere parallel geschaltete Leistungshalbleiterschalter (104a, 104b, 401a, 401b, 402a, 402b) umfasst,
    - einem Wechselspannungsanschluss (106) für jede der Halbbrücken,
    - einer Gate-Treiberschaltung (105a, 105b, 303a, 303b, 304a, 304b) für jede der Schalteinheiten,
    - einem Kommutierungskondensator (103, 203a, 203b) parallel zur Halbbrücke,
    - einer Modulsteuerung (107),
    - einer Messeinrichtung (113) zur Bestimmung des Stroms zum Wechselspannungsanschluss,

    wobei die Halbbrücke, der Kommutierungskondensator (103, 203a, 203b) und die Gate-Treiberschaltung (105a, 105b, 303a, 303b, 304a, 304b) auf einem gemeinsamen homogenen Schaltungsträger (101) angeordnet sind.

2. Leistungshalbleiterschaltung (100, 200, 300, 400) nach Anspruch 1 mit genau einer Halbbrücke.

3. Leistungshalbleiterschaltung (100, 200, 300, 400) nach Anspruch 1 mit genau zwei parallel geschalteten Halbbrücken.

4. Leistungshalbleiterschaltung (100, 200, 300, 400) nach Anspruch 1 mit genau drei Halbbrücken.

5. Leistungshalbleiterschaltung (100, 200, 300, 400) nach einem der vorangehenden Ansprüche, bei der der Kommutierungskondensator (103, 203a, 203b) eine Kapazität von höchstens 10 $\mu$F aufweist.

6. Leistungshalbleiterschaltung (100, 200, 300, 400) nach einem der vorangehenden Ansprüche mit einer Einrichtung (108) zur Messung der Spannung des Kommutierungskondensators (103, 203a, 203b).

7. Leistungshalbleiterschaltung (100, 200, 300, 400) nach einem der vorangehenden Ansprüche mit einer Einrichtung (109) zur Messung der Temperatur.

8. Leistungshalbleiterschaltung (100, 200, 300, 400) nach einem der vorangehenden Ansprüche, bei der der Kommutierungskondensator (103, 203a, 203b) und die Halbbrücke oder Halbbrücken als Kommutierungszelle aufgebaut sind.

9. Leistungshalbleiterschaltung (100, 200, 300, 400) nach einem der vorangehenden Ansprüche mit einer Induktivität (110) zwischen dem Mittelpunkt jeder Halbbrücke und dem Wechselspannungsanschluss (106).

10. Leistungshalbleiterschaltung (100, 200, 300, 400) nach einem der vorangehenden Ansprüche mit einem zweiten Wechselspannungsanschluss (112).

11. Leistungshalbleiterschaltung (100, 200, 300, 400) nach Anspruch 10 mit einem Filterkondensator (111) zwischen dem Wechselspannungsanschluss (106) und dem zweiten Wechselspannungsanschluss (112).

12. Leistungshalbleiterschaltung (100, 200, 300, 400) nach einem der vorangehenden Ansprüche, bei der die Leistungshalbleiterschalter durch IGBTs oder MOSFETs gebildet sind.

13. Leistungshalbleiterschaltung (100, 200, 300, 400) nach einem der vorangehenden Ansprüche, bei der die Leistungshalbleiterschalter (104a, 104b, 301a, 301b, 302a, 302b) durch Wide-Bandgap-Halbleiterschalter, insbesondere GaN-Schalter, gebildet sind.

14. Leistungshalbleiterschaltung (100, 200, 300, 400) nach einem der vorangehenden Ansprüche, bei der die Modulsteuerung (107) so ausgestaltet ist, dass sie eine Pulsweitenmodulation der Halbbrücke mit einer von außen über eine Schnittstelle an die Modulsteuerung (107) vorgebbaren Schaltfrequenz, Phase und/oder Ausgangsfrequenz durchführen kann.

15. Leistungshalbleiterschaltung (100, 200, 300, 400) nach einem der vorangehenden Ansprüche, bei der die Modulsteuerung (107) ein serielles Interface (107a, 107b) zur Kommunikation aufweist.

FIG 1

FIG 2

FIG 3

EP 3 358 738 A1

FIG 4

**FIG 5**

**FIG 6**

Europäisches
Patentamt

European
Patent Office

Office européen
des brevets

## EUROPÄISCHER RECHERCHENBERICHT

Nummer der Anmeldung

EP 17 15 4499

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | US 2005/253165 A1 (PACE GARY [US] ET AL) 17. November 2005 (2005-11-17) * Abbildungen 1, 3 * * Absatz [0033] * ----- | 1-15 | INV. H02M7/537 H02M7/00 H01L29/00 H03K17/567 H03K17/687 |
| Y | WO 2016/177491 A1 (BOSCH GMBH ROBERT [DE]) 10. November 2016 (2016-11-10) * Abbildungen 1, 4 * * Seite 10, Zeile 9 - Zeile 13 * * Seite 13, Zeile 4 - Zeile 15 * ----- | 1-15 | |
| A | DE 10 2015 210802 A1 (SIEMENS AG [DE]) 15. Dezember 2016 (2016-12-15) * Abbildung 2 * ----- | 1-15 | |

RECHERCHIERTE
SACHGEBIETE (IPC)

H02M
H01L
H03K

Der vorliegende Recherchenbericht wurde für alle Patentansprüche erstellt

| Recherchenort | Abschlußdatum der Recherche | Prüfer |
|---|---|---|
| Den Haag | 14. Juli 2017 | Simon, Volker |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
..........................................................................
& : Mitglied der gleichen Patentfamilie, übereinstimmendes
   Dokument

EPO FORM 1503 03.82 (P04C03)

EP 3 358 738 A1

**ANHANG ZUM EUROPÄISCHEN RECHERCHENBERICHT**
**ÜBER DIE EUROPÄISCHE PATENTANMELDUNG NR.**          EP 17 15 4499

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-07-2017

| Im Recherchenbericht angeführtes Patentdokument | Datum der Veröffentlichung | Mitglied(er) der Patentfamilie | Datum der Veröffentlichung |
|---|---|---|---|
| US 2005253165 A1 | 17-11-2005 | CA 2565453 A1<br>CN 101088221 A<br>EP 1751862 A2<br>NO 337422 B1<br>US 2005253165 A1<br>US 2008007318 A1<br>WO 2005104743 A2 | 10-11-2005<br>12-12-2007<br>14-02-2007<br>11-04-2016<br>17-11-2005<br>10-01-2008<br>10-11-2005 |
| WO 2016177491 A1 | 10-11-2016 | DE 102015208150 A1<br>WO 2016177491 A1 | 10-11-2016<br>10-11-2016 |
| DE 102015210802 A1 | 15-12-2016 | DE 102015210802 A1<br>WO 2016198461 A1 | 15-12-2016<br>15-12-2016 |

EPO FORM P0461

Für nähere Einzelheiten zu diesem Anhang : siehe Amtsblatt des Europäischen Patentamts, Nr.12/82